# EUROPEAN PATENT APPLICATION

(11) **EP 4 803 653 A1**
(43) Date of publication of application: **09.09.2026**
(21) Application number: 26155481.0
(22) Date of filing: 30.01.2026
(51) Int. Cl.: C23C 14/18, C23C 14/24, C23C 14/54, H10N 30/06, G01N 29/24

(54) **CRYSTAL SENSOR AND THIN-FILM DEPOSITION DEVICE INCLUDING THE SAME**

(30) Priority: 07.03.2025 KR 20250029530
(71) Applicant: Samsung Display Co., Ltd., Yongin-si, Gyeonggi-do 17113 (KR)
(72) Inventor: KIM, Jin Gul, Yongin-si (KR); CHOI, Kun Hoon, Yongin-si (KR); SON, Ho Bin, Yongin-si (KR); NOH, Sok Won, Yongin-si (KR); YU, Sang Hee, Yongin-si (KR)
(74) Representative: Marks & Clerk LLP

(57) **Abstract**

A crystal sensor includes: a crystal disc; and an electrode layer located on the crystal disc. The crystal sensor is configured to sense an amount of a deposition material deposited on a substrate by measuring a degree of changes in a natural vibration frequency of the crystal disc as the deposition material is deposited on the electrode layer. A calculated binding energy between the electrode layer and the deposition material satisfies the following equation: ${E}_{A} - \left({E}_{B}+{E}_{C}\right) \leq - 3 eV ,$ where E_{A} denotes a total enthalpy of the electrode layer and the deposition material calculated when the electrode layer and the deposition material are bonded together, E_{B} denotes an enthalpy of the electrode layer calculated when the electrode layer is not bonded with the deposition material, and E_{C} denotes an enthalpy of the deposition material calculated when the deposition material is not bonded with the electrode layer.

## Description

### BACKGROUND

### 1. Field of the Disclosure

The present disclosure relates to a crystal sensor and a thin-film deposition device including the same.

### 2. Description of the Related Art

As the information-oriented society evolves, various demands for display devices are ever increasing. A display device may be a flat-panel display device such as a liquid-crystal display device, a field emission display device, and a light-emitting display device. Light-emitting display devices may include an organic light-emitting display device including organic light-emitting emitting diodes as light-emitting elements, or a light-emitting diode display device including inorganic light-emitting diodes such as light-emitting diodes (LEDs) as light-emitting elements.

A plurality of thin films may be formed on a substrate of a display device. In a method for forming a thin-film by deposition using a thin-film deposition device, it is necessary to accurately measure the amount of the deposition material in order to form a thin film of a constant thickness on the substrate.

### SUMMARY

Aspects of the present disclosure provide a crystal sensor that includes an electrode layer with high sensitivity to a deposition material and can accurately measure the deposition amount of the deposition material. The electrode layer of the crystal sensor may be selected by calculating the binding energy between the electrode layer and the deposition material.

It should be noted that objects of the present disclosure are not limited to the above-mentioned object; and other objects of the present disclosure will be apparent to those skilled in the art from the following descriptions.

According to an aspect of embodiments of the present disclosure, a crystal sensor includes: a crystal disc; and an electrode layer on the crystal disc, where the crystal sensor is configured to sense an amount of a deposition material deposited on a substrate by measuring a degree of changes in a natural vibration frequency of the crystal disc as the deposition material is deposited on the electrode layer, wherein a calculated binding energy between the electrode layer and the deposition material satisfies the following equation:${E}_{A} - \left({E}_{B}+{E}_{C}\right) \leq - 3 electron volts \left(eV\right) ,$ wherein E_{A} denotes a total enthalpy of the electrode layer and the deposition material calculated when the electrode layer and the deposition material are bonded together, E_{B} denotes an enthalpy of the electrode layer calculated when the electrode layer is not bonded with the deposition material, and E_{C} denotes an enthalpy of the deposition material calculated when the deposition material is not bonded with the electrode layer. In some examples, the binding energy may be calculated using the Vienna Ab Initio Simulation Package (VASP).

The electrode layer may include chromium (Cr) or tantalum (Ta).

The deposition material may be lithium (Li).

The deposition material may be ytterbium (Yb), and the electrode layer may contain gold (Au), tantalum (Ta), or nickel (Ni).

The deposition material may be magnesium (Mg), and the electrode layer may contain tantalum (Ta).

The crystal sensor may further include: an adhesive layer between the crystal disc and the electrode layer.

The adhesive layer may include at least one of: chromium (Cr), aluminum (Al), titanium (Ti), gold (Au), silver (Ag), nickel (Ni), molybdenum (Mo), and tantalum (Ta).

According to an aspect of embodiments of the present disclosure, a thin-film deposition device includes: a chamber; a support placed inside the chamber and which supports a substrate; a deposition unit located opposite to the support and is configured to perform a process of depositing a deposition material on the substrate; and a crystal sensor installed adjacent to the deposition unit and which detects a deposition rate of the deposition material. The crystal sensor includes: a crystal disc; and an electrode layer on the crystal disc, where a calculated binding energy between the electrode layer and the deposition material satisfies the following equation: ${E}_{A} - \left({E}_{B}+{E}_{C}\right) \leq - 3 eV ,$ wherein E_{A} denotes a total enthalpy of the electrode layer and the deposition material calculated when the electrode layer and the deposition material are bonded together, E_{B} denotes an enthalpy of the electrode layer calculated when the electrode layer is not bonded with the deposition material, and E_{C} denotes an enthalpy of the deposition material calculated when the deposition material is not bonded with the electrode layer. In some examples, the binding energy may be calculated using the Vienna Ab Initio Simulation Package (VASP).

The deposition unit may include: a deposition source for accommodating the deposition material; and a heater for heating the deposition source.

The electrode layer may include chromium (Cr) or tantalum (Ta).

The deposition material may be lithium (Li).

The thin-film deposition device may further include: an adhesive layer between the crystal disc and the electrode layer.

The adhesive layer may include at least one of: chromium (Cr), aluminum (Al), titanium (Ti), gold (Au), silver (Ag), nickel (Ni), molybdenum (Mo), and tantalum (Ta).

Variations in the deposition rate may be equal to or less than 0.1 angstroms per second (Å/s).

The thin-film deposition device may further include: a controller for controlling a temperature of the heater according to the deposition rate detected by the crystal sensor.

According to an aspect of embodiments of the present disclosure, there may be provided an electronic device including: a display module configured to provide images; and a processor configured to transmit an image data signal to the display module, where the display module is fabricated by a process including depositing a deposition material on a substrate. The process is performed by a thin-film deposition device including a crystal sensor, where the crystal sensor includes: a crystal disc; and an electrode layer located on the crystal disc, and a calculated binding energy between the electrode layer and the deposition material satisfies the following equation: ${E}_{A} - \left({E}_{B}+{E}_{C}\right) \leq - 3 eV$ where E_{A} denotes a total enthalpy of the electrode layer and the deposition material calculated when the electrode layer and the deposition material are bonded together, E_{B} denotes an enthalpy of the electrode layer calculated when the electrode layer is not bonded with the deposition material, and E_{C} denotes an enthalpy of the deposition material calculated when the deposition material is not bonded with the electrode layer. In some examples, the binding energy may be calculated using the Vienna Ab Initio Simulation Package (VASP).

The electronic device may further include: an adhesive layer located between the crystal disc and the electrode layer.

The adhesive layer may include at least one of: chromium (Cr), aluminum (Al), titanium (Ti), gold (Au), silver (Ag), nickel (Ni), molybdenum (Mo), and tantalum (Ta).

According to an embodiment of the present disclosure, a crystal sensor uses a material having a strong bonding force with a deposition material as an electrode layer, and can accurately detect the amount and deposition rate of the deposition material deposited on the surface of the electrode layer. In particular, the detected deposition rate can be constant even when a material with a small element weight, such as lithium (Li) and magnesium (Mg), is used as the deposition material.

It should be noted that effects of the present disclosure are not limited to those described above and other effects of the present disclosure will be apparent to those skilled in the art from the following descriptions.

At least some of the above and other features of the invention are set out in the claims.

### BRIEF DESCRIPTION OF THE DRAWINGS

The above and other aspects and features of the present disclosure will become more apparent by describing in detail example embodiments thereof with reference to the attached drawings, in which:
FIG. 1 is a plan view of a display device according to an embodiment of the present disclosure.
FIG. 2 is an exploded perspective view of a display device according to an embodiment of the present disclosure.
FIG. 3 is a side view of a display device according to an embodiment of the present disclosure.
FIG. 4 is a cross-sectional view of a display panel according to an embodiment of the present disclosure.
FIG. 5 is a view of a thin-film deposition device according to an embodiment of the present disclosure.
FIG. 6 is a perspective view of a crystal sensor according to an embodiment of the present disclosure.
FIG. 7 is a plan view showing a sensing surface of a crystal sensor according to an embodiment of the present disclosure.
FIG. 8 is a plan view showing a surface of a crystal sensor according to an embodiment of the present disclosure.
FIG. 9 is a plan view showing the opposite surface of the crystal sensor according to the embodiment of the present disclosure.
FIG. 10 is a cross-sectional view according to a first embodiment, taken along line A - A' of FIG. 9.
FIG. 11 is a cross-sectional view according to a second embodiment, taken along line A - A' of FIG. 9.
FIG. 12 is a transmission electron microscopy (TEM) image of a cross-section of a material in which aluminum (Al) / chromium (Cr) / lithium (Li) are sequentially stacked on one another.
FIG. 13 is a transmission electron microscopy (TEM) image of a cross-section of a material in which aluminum (Al) / lithium (Li) are sequentially stacked on one another.
FIG. 14 is a transmission electron microscopy (TEM) image of a cross-section of a material in which aluminum (Al) / titanium (Ti) / lithium (Li) are sequentially stacked on one another.
FIG. 15 is a graph showing the deposition rate over time of a crystal sensor including tantalum (Ta) as an electrode layer when lithium (Li) is deposited.
FIG. 16 is a graph showing the deposition rate over time of a crystal sensor including chromium (Cr) as an electrode layer when lithium (Li) is deposited.
FIG. 17 is a graph showing the deposition rate over time of a crystal sensor including aluminum (Al) as an electrode layer when lithium (Li) is deposited.
FIG. 18 is a graph showing the deposition rate over time of a crystal sensor including gold (Au) as an electrode layer when lithium (Li) is deposited.
FIG. 19 is a graph showing the deposition rate over time of a crystal sensor including titanium (Ti) as an electrode layer when lithium (Li) is deposited.
FIG. 20 is a graph showing the deposition rate over time of a crystal sensor including molybdenum (Mo) as an electrode layer when lithium (Li) is deposited.
FIG. 21 is a graph showing the deposition rate over time of a crystal sensor including chromium (Cr) as an electrode layer when lithium (Li) is deposited.
FIG. 22 is a graph showing the deposition rate over time of a crystal sensor including aluminum (Al) as an electrode layer when lithium (Li) is deposited.
FIG. 23 is a graph showing the deposition rate over time of a crystal sensor including silver (Ag) as an electrode layer when lithium (Li) is deposited.
FIG. 24 is a graph showing the deposition rate over time by sequentially using a crystal sensor including gold (Au) and chromium (Cr) as an electrode layer when silver (Ag) is deposited.
FIG. 25 is a block diagram of an electronic device according to an embodiment of the present disclosure.
FIG. 26 is a view showing electronic devices according to a variety of embodiments of the present disclosure.

### DETAILED DESCRIPTION

The advantages and features of the present invention, and the methods for achieving them, will become clear with reference to the embodiments described below in detail with the accompanying drawings. However, the present invention is not limited to the embodiments disclosed below, but may be implemented in various different forms, and these embodiments are provided only to make the disclosure of the present invention complete and to fully inform those skilled in the art of the invention of the scope of the invention, and the present invention is defined only by the scope of the claims.

When elements or layers are referred to as "on" another element or layer, this includes all cases where another layer or another element is interposed directly over or in the middle of the other element. The same reference numerals refer to the same components throughout the specification. The shapes, sizes, ratios, angles, numbers, etc. disclosed in the drawings for explaining the embodiments are examples, and therefore the present invention is not limited to the matters illustrated.

Although the terms "first" and "second" are used to describe various components, these components are not limited by these terms. These terms are only used to distinguish one component from another. Therefore, it goes without saying that the first component mentioned below may be the second component within the technical idea of the present invention.

Each of the features of the various embodiments of the present invention may be partially or wholly combined or combined with each other, and various technical connections and operations are possible, and each embodiment may be implemented independently of each other or may be implemented together in a related relationship.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Specific embodiments will be described below with reference to the attached drawings.

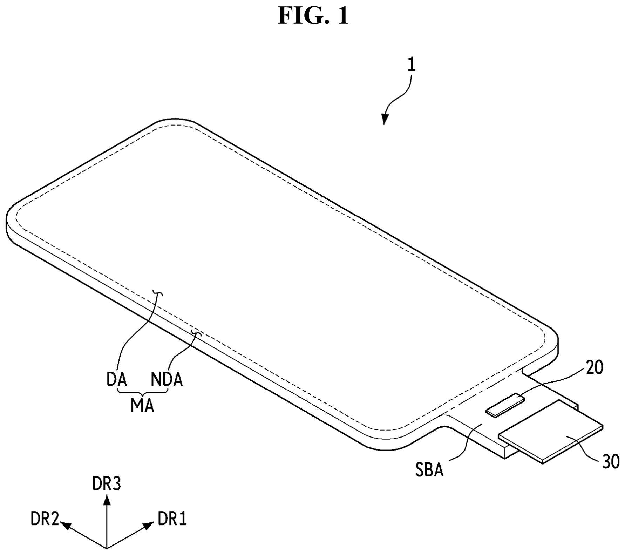

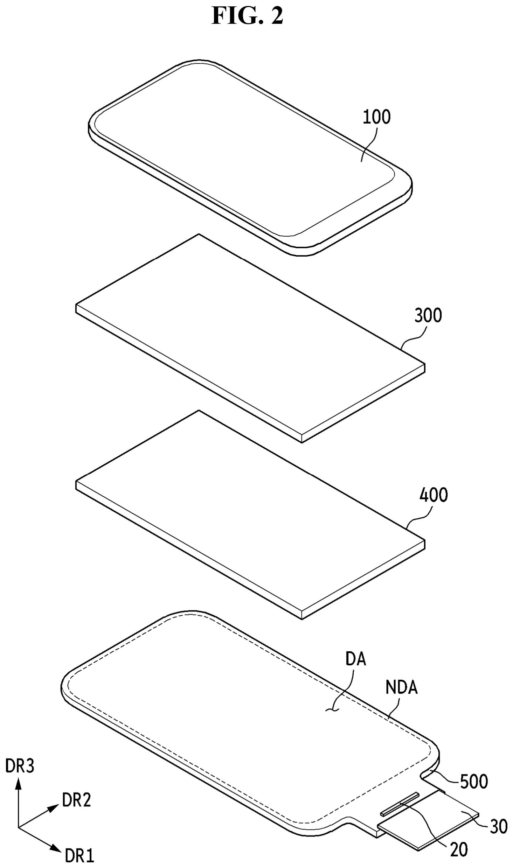

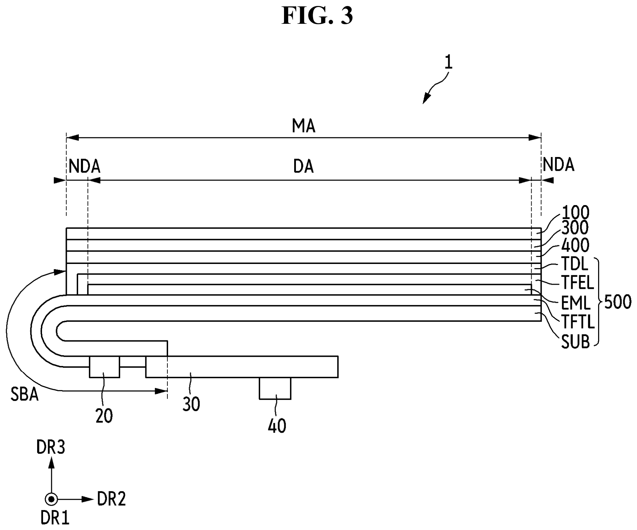

FIG. 1 is a plan view of a display device according to an embodiment of the present disclosure. FIG. 2 is an exploded perspective view of a display device according to an embodiment of the present disclosure. FIG. 3 is a side view of a display device according to an embodiment of the present disclosure.

Referring to FIGS. 1 to 3, the display device 1 according to the embodiment may include a window member 100, an adhesive member 200, an anti-fingerprint film 300, an anti-reflection film 400 and a display panel 500.

A display device 1 according to the embodiment of the present disclosure is for displaying moving images or still images. The display device 1 may be used as the display screen of portable electronic devices such as a mobile phone, a smart phone, a tablet PC, a smart watch, a watch phone, a mobile communications terminal, an electronic notebook, an electronic book, a portable multimedia player (PMP), a navigation device and a ultra mobile PC (UMPC), as well as the display screen of various products such as a television, a notebook, a monitor, a billboard and the Internet of Things.

According to an embodiment of the present disclosure, the display device 1 may be a light-emitting display device such as an organic light-emitting display device using organic light-emitting diodes, a quantum-dot light-emitting display device including quantum-dot light-emitting layer, an inorganic light-emitting display device including an inorganic semiconductor, and a micro-LED display device using micro or nano light-emitting diodes (micro LEDs or nano LEDs). In the following description, an organic light-emitting display device is described as an example of the display device 1 according to the example embodiment. It is, however, to be understood that embodiments of the present disclosure are not limited thereto.

The display device 1 includes a display panel 500, a display driver circuit 20 and a circuit board 30.

The display panel 500 may be formed in a rectangular plane having shorter sides in the first direction DR1 and longer sides in the second direction DR2 intersecting the first direction DR1. In addition, the display panel 500 may have a thickness in the third direction DR3 that intersects the first direction DR1 and the second direction DR2. Each of the corners where the shorter side in the first direction DR1 meets the longer side in the second direction DR2 may be rounded with a curvature or may be a right angle. The shape of the display panel 500 when viewed from the top is not limited to a quadrangular shape, but may be formed in a different polygonal shape, a circular shape, or an elliptical shape. The display panel 500 may be formed flat, but the present disclosure is not limited thereto. For example, the display panel 500 may be formed at left and right ends, and may include a curved portion having a constant curvature or a varying curvature. In addition, the display panel 500 may be flexible so that it can be curved, bent, folded or rolled.

The display panel 500 may include the main area MA and a subsidiary area SBA.

The main area MA may include a display area DA where images are displayed, and a non-display area NDA around the display area DA. The display area DA may occupy most of the main area MA. The display area DA may be disposed at the center of the main area MR. The non-display area NDA may be disposed adjacent to the display area DA. The non-display area NDA may be located on the outer side of the display area DA. The non-display area NDA may surround the display area DA. The non-display area NDA may be defined as the edge area of the display panel 500.

The subsidiary area SBA may be extended from one side of the main area MA in the first direction DR1. The length of the subsidiary area SBA in the first direction DR1 may be smaller than the length of the main area MA in the first direction DR1. The length of the subsidiary area SBA in the second direction DR2 may be less than the length of the main area MA in the second direction DR2 or may be substantially equal to it. The subsidiary area SBA may be bent and may be located under the display panel 500. In this instance, the subsidiary area SBA may overlap with the main area MA in the third direction DR3.

The display driver circuit 20 may generate signals and voltages for driving the display panel 500. The display driver circuit 20 may be implemented as an integrated circuit (IC) and may be attached to the subsidiary area SBA of the display panel 500 by a chip on glass (COG) technique, a chip on plastic (COP) technique, or an ultrasonic bonding. Alternatively, the display driver circuit 20 may be attached on the circuit board 30 by the chip-on-film (COF) technique.

The circuit board 30 may be attached to one end of the subsidiary area SBA of the display panel 500. Accordingly, the circuit board 30 may be electrically connected to the display panel 500 and the display driver circuit 20. The display panel 500 and the display driver circuit 20 may receive digital video data, timing signals, and driving voltages through the circuit board 30. The circuit board 30 may be a flexible printed circuit board, a printed circuit board, or a flexible film such as a chip on film.

The touch driver circuit 40 may be located on the circuit board 30. The touch driver circuit 40 may be implemented as an integrated circuit (IC) and may be attached on the circuit board 30.

The touch driver circuit 40 may be electrically connected to a plurality of driving electrodes and a plurality of sensing electrodes of the touch detecting layer TDL. The touch driver circuit 40 may apply a touch driving signal to a plurality of driving electrodes, and may sense a touch detection signal, for example, a change in mutual capacitance, of each of a plurality of touch nodes a plurality of sensing electrodes. The touch driver circuit 40 may determine whether there is a user's touch or near proximity, based on the touch sensing signal of each of the plurality of touch nodes. A user's touch refers to that an object such as the user's finger or a pen is brought into contact with the front surface of the display device 1 disposed on the touch detecting layer TDL. A user's near proximity refers to that an object such as the user's finger and a pen is hovering over the front surface of the display device 1.

The anti-fingerprint film 300 may be formed on the window member 100. The window member 100 is made of a transparent material, and may be, for example, glass or plastic. For example, the window member 100 may be an ultra thin glass (UTG) having a thickness of 0.1 mm or less or a transparent polyimide film.

The anti-fingerprint film 300 may be located on the front surface of the window member 100. The anti-fingerprint film 300 can prevent a user's fingerprint from being left on the display device 1.

The anti-reflection film 400 may be formed on the window member 100. The anti-fingerprint film 300 and/or an anti-reflection film 400 may be deposited on the window member 100 in deposition equipment.

By depositing the anti-fingerprint film 300 and/or the anti-reflection film 400 on the window member 100 rather than by attaching them with an adhesive, the adhesive strength between the window member 100 and the anti-fingerprint film 300 and/or the anti-reflection film 400 can be further improved.

The anti-reflection film 400 may be located on the front surface of the display panel 500. The anti-reflection film 400 may include a plurality of refractive layers having different refractive indices. The anti-reflection film 400 can reduce reflected light through the plurality of refractive layers.

The anti-reflection film 400 may be arranged in multiple layers by alternating high-refractive layers and low-refractive layers using the distributed Bragg reflector (DBR) characteristics.

The refractive index of the low-refractive layer may range from 1.20 to 1.60, but the present disclosure is not limited thereto. The low-refractive layer may include, but is not limited to, at least one of silicon resin, silica, silicon oxide (SiOx), and silicon dioxide (SiO₂). The low-refractive layer is not limited to the above-listed materials and may include any material as long as it can exhibit a low refractive index.

The refractive index of the high-refractive layer may range from 1.70 to 2.80, but the present disclosure is not limited thereto. The high-refractive layer may include at least one of: silicon nitride (Si₃N₄), aluminum nitride (AlN), zirconium nitride (ZrN), chromium nitride (CrN), titanium nitride (TiN), manganese nitride (Mn₄N), iron nitride (FeNx), cobalt nitride (CoNx), nickel nitride (Ni₃N), copper nitride (Cu₃N), zinc nitride (Zn₂N₃), vanadium nitride (VN), molybdenum nitride (Mo₂N), hafnium nitride (HfN), germanium nitride (Ge₃N₄), lead nitride (Pb(N₃)₂), titanium niobate (Ti₄Nb₃O₃₅), titanium dioxide (TiO₂), zirconium dioxide (ZrO₂), lithium niobate (LiNbO₃), lithium tantalate (LiTaO₃), and Lanthanum Titanium (LaTiO₂). The high-refractive layer is not limited to the above-listed materials and may include any material as long as it can exhibit a high refractive index.

The thickness of the low-refractive layer may be equal to or different from the thickness of the high-refractive layer. The thickness of the low-refractive layer and the thickness of the high-refractive layer may be determined by considering the characteristics of the anti-reflection film 400, such as the target reflection wavelength, hardness, durability, and reflectance.

A light-blocking layer (not shown) for absorbing light incident from the outside, a buffer layer (not shown) for absorbing impact from the outside, and a heat-dissipation layer (not shown) for efficiently discharging heat from the display panel 500 may be further included under the display panel 500.

The light-blocking layer can block transmission of light, thereby preventing elements disposed under the light-blocking layer from being seen from above the display panel 500. The light-blocking layer may include a light-absorbing material such as a black pigment and a black dye.

The buffer layer can absorb external shock to prevent the display panel 500 from being damaged. The buffer layer may be made up of a single layer or multiple layers. For example, the buffer layer may be formed of a polymer resin such as polyurethane, polycarbonate, polypropylene and polyethylene, or may be formed of a material having elasticity such as a rubber and a sponge obtained by foaming a urethane-based material or an acrylic-based material.

The heat dissipation layer may include a first heat dissipation layer including graphite or carbon nanotubes, and a second heat dissipation layer formed as a thin metal film such as copper, nickel, ferrite and silver, which can block electromagnetic waves and have high thermal conductivity.

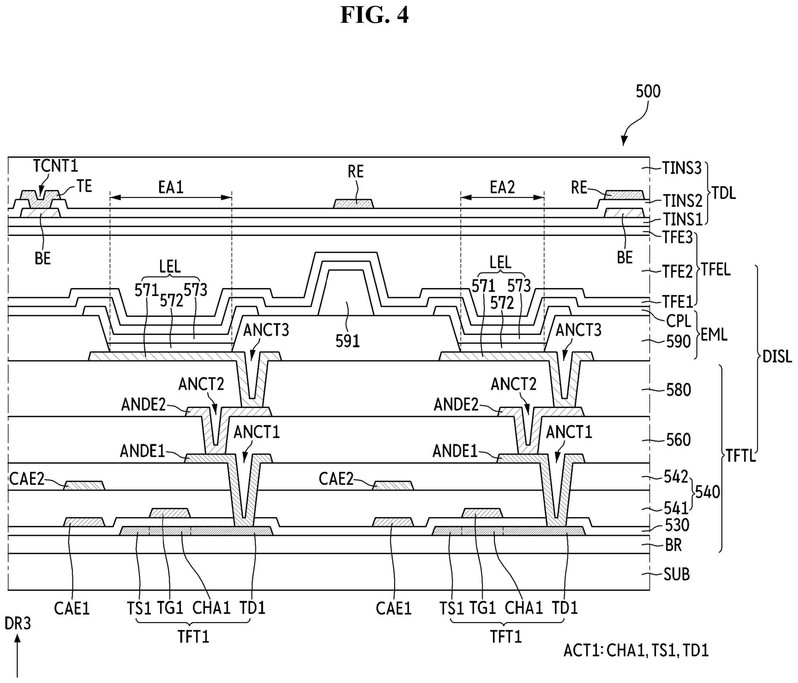

FIG. 4 is a cross-sectional view of a display panel according to an embodiment of the present disclosure.

Referring to FIG. 4, the display panel 500 may include a substrate SUB, a display layer DISL disposed on the substrate SUB, and a touch detecting layer TDL disposed on the display layer DISL. The display layer DISL may include a thin-film transistor layer TFTL, an emission material layer EML, and an encapsulation layer TFEL.

The thin-film transistor layer TFTL may be located on the substrate SUB. The thin-film transistor layer TFTL may include a barrier layer BR, a thin-film transistor TFT1, a first capacitor electrode CAE1, a second capacitor electrode CAE2, a first anode connection electrode ANDE1, a second anode connection electrode ANDE2, a gate insulator 530, a first interlayer dielectric layer 541, a second interlayer dielectric layer 542, a first planarization layer 560, a second planarization layer 580.

The substrate SUB may be made of an insulating material such as a polymer resin. For example, the substrate SUB may be made of polyimide. The substrate SUB may be a flexible substrate that can be bent, folded, or rolled.

The barrier layer BR may be located on the substrate SUB. The barrier layer BR is a film for protecting the thin-film transistors of the thin-film transistor layer TFTL and an emission layer 572 of the emission material layer EML. The barrier layer BR may be made up of multiple inorganic films stacked on one another alternately. For example, the barrier layer BR may be made up of multiple layers in which one or more inorganic layers of a silicon nitride layer, a silicon oxynitride layer, a silicon oxide layer, a titanium oxide layer and an aluminum oxide layer are alternately stacked on one another.

The thin-film transistor layer TFTL may be located on the substrate SUB. The thin-film transistor layer TFTL may be disposed in the main area MA and the subsidiary area SBA. The thin-film transistor layer TFTL includes thin-film transistors.

The thin-film transistor TFT1 may be placed on the barrier layer BR. An active layer ACT1 of the thin-film transistor TFT1 may be located on the barrier layer BR. The active layer ACT1 of the thin-film transistor TFT1 may include polycrystalline silicon, monocrystalline silicon, low-temperature polycrystalline silicon, amorphous silicon, or an oxide semiconductor.

The active layer ACT1 may include a channel region CHA1, a source region TS1 and a drain region TD1. The channel region CHA1 may overlap with a gate electrode TG1 in the third direction DR3 that is the thickness direction of the substrate SUB. The source region TS1 may be disposed on one side of the channel region CHA1, and the drain region TD1 may be disposed on the opposite side of the channel region CHA1. The source region TS1 and the drain region TD1 may not overlap with the gate electrode TG1 in the third direction DR3. The source region TS1 and the drain region TD1 may be formed by doping a silicon semiconductor or an oxide semiconductor with ions or impurities to have conductivity.

The gate insulator 530 may be disposed on the active layer ACT1 of the thin-film transistor TFT1. The gate insulator 530 may include an inorganic layer, for example, a silicon nitride layer, a silicon oxynitride layer, a silicon oxide layer, a titanium oxide layer, or an aluminum oxide layer.

The gate electrode TG1 of the thin-film transistor TFT1 and the first capacitor electrode CAE1 may be disposed on the gate insulator 530. The gate electrode TG1 may overlap with the channel region CHA1 in the third direction DR3. Although the gate electrode TG1 and the first capacitor electrode CAE1 are spaced apart from each other in the example shown in FIG. 4, the gate electrode TG1 and the first capacitor electrode CAE1 may be connected with each other as a single piece. The gate electrode TG1 and the first capacitor electrode CAE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first interlayer dielectric layer 541 may be disposed on the gate electrode TG1 of the thin-film transistor TFT1 and the first capacitor electrode CAE1. The first interlayer dielectric layer 541 may include an inorganic layer, for example, a silicon nitride layer, a silicon oxynitride layer, a silicon oxide layer, a titanium oxide layer, or an aluminum oxide layer. The first interlayer dielectric layer 541 may be made up of multiple inorganic films.

The second capacitor electrode CAE2 may be located on the first interlayer dielectric layer 541. The second capacitor electrode CAE2 may overlap the first capacitor electrode CAE1 of the thin-film transistor TFT1 in the third direction DR3. In addition, when the gate electrode TG1 and the first capacitor electrode CAE1 are formed as a single piece, the second capacitor electrode CAE2 may overlap the gate electrode TG1 in the third direction DR3. Since the first interlayer dielectric layer 541 has a dielectric constant, a capacitor can be formed by the first capacitor electrode CAE1, the second capacitor electrode CAE2 and the first interlayer dielectric layer 541 arranged therebetween. The second capacitor electrode CAE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric layer 542 may be located over the second capacitor electrode CAE2. The second interlayer dielectric layer 542 may include an inorganic layer, for example, a silicon nitride layer, a silicon oxynitride layer, a silicon oxide layer, a titanium oxide layer, or an aluminum oxide layer. The second interlayer dielectric layer 542 may be made of a plurality of inorganic films.

A first anode connection electrode ANDE1 may be disposed on the second interlayer dielectric layer 542. The first anode connection electrode ANDE1 may be connected to the drain electrode DT1 of the thin-film transistor TFT1 through a first connection contact hole ANCT1 that penetrates the gate insulator 530, the first interlayer dielectric layer 541 and the second interlayer dielectric layer 542. The first anode connection electrode ANDE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first planarization layer 560 may be disposed over the first anode connection electrode ANDE1 for providing a flat surface over level differences due to the thin-film transistor TFT1. The first planarization layer 560 may include an organic layer such as an acryl resin, an epoxy resin, a phenolic resin, a polyamide resin and a polyimide resin.

A second anode connection electrode ANDE2 may be located on the first planarization layer 560. The second anode connection electrode ANDE2 may be connected to the first anode connection electrode ANDE1 through a second connection contact hole ANCT2 penetrating the first planarization layer 560. The second anode connection electrode ANDE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second planarization layer 580 may be located on the second anode connection electrode ANDE2. The second planarization layer 180 may be formed as an organic layer such as an acryl resin, an epoxy resin, a phenolic resin, a polyamide resin and a polyimide resin.

The emission material layer EML may be located on the thin-film transistor layer TFTL. The emission material layer EML may be located in the display area DA of the main area MA. The emission material layer EML includes light-emitting elements arranged in emission areas.

The emission material layer EML including light-emitting elements LEL and a bank 590 may be located on the second planarization layer 580. Each of the light-emitting elements LEL includes a pixel electrode 571, an emission layer 572, and a common electrode 573.

The pixel electrode 571 may be located on the second planarization layer 580. The pixel electrode 571 may be connected to the second anode connection electrode ANDE2 through a third connection contact hole ANCT3 penetrating the second planarization layer 580.

In the top-emission structure in which light exits from the emission layer 572 toward the common electrode 573, the pixel electrode 571 may be made of a metal material having a high reflectivity such as a stack structure of aluminum and titanium (Ti / Al / Ti), a stack structure of aluminum (Al) and ITO (Indium Tin Oxide) (ITO/ Al /ITO), an APC alloy and a stack structure of an APC alloy and ITO (ITO / APC / ITO). The APC alloy is an alloy of silver (Ag), palladium (Pd) and copper (Cu).

The bank 590 may partition the pixel electrode 571 on the second planarization layer 580 to define the emission areas EA1 and EA2. The bank 590 may be located to cover the edges of the pixel electrode 571. The bank 590 may include an organic film such as an acryl resin, an epoxy resin, a phenolic resin, a polyamide resin and a polyimide resin.

In each of the first emission area EA1 and the second emission area EA2, the pixel electrode 571, the emission layer 572 and the common electrode 573 are stacked on one another sequentially, so that holes from the pixel electrode 571 and electrons from the common electrode 573 are recombined with each other in the emission layer 572 to emit light.

The emission layer 572 may be placed on the pixel electrode 571 and the bank 590. The emission layer 572 may include an organic material to emit light of a particular color. For example, the emission layer 572 may include a hole transporting layer, an organic material layer, and an electron transporting layer.

The common electrode 573 may be located on the emission layer 572. The common electrode 573 may cover the emission layer 572. The common electrode 573 may be a common layer formed commonly across the first emission area EA1 and the second emission area EA2.

In the top-emission organic light-emitting diode, the common electrode 573 may include a transparent conductive material (TCP) such as ITO and IZO that can transmit light, or a semi-transmissive conductive material such as magnesium (Mg), silver (Ag) and an alloy of magnesium (Mg) and silver (Ag). When the common electrode 173 is made of a semi-transmissive metal material, the light extraction efficiency can be increased by using microcavities.

A spacer 591 may be located on the bank 590. The spacer 591 may support a mask during a process of fabricating the emission layer 572. The spacer 591 may be implemented as an organic layer such as an acryl resin, an epoxy resin, a phenolic resin, a polyamide resin and a polyimide resin.

According to some embodiments of the present disclosure, the display panel 500 may further include a capping layer CPL located on the common electrode 573. The capping layer CPL may be made of an inorganic material. For example, the capping layer CPL may include at least one of: silicon nitride, aluminum nitride, zirconium nitride, titanium nitride, hafnium nitride, tantalum nitride, silicon oxide, aluminum oxide, titanium oxide, tin oxide, cerium oxide and silicon oxynitride.

The encapsulation layer TFEL may be located on the emission material layer EML. The encapsulation layer TFEL may be disposed in the display area DA and the non-display area NDA of the main area MA. The encapsulation layer TFEL includes at least one inorganic film and at least one organic film for encapsulating the emission material layer.

The encapsulation layer TFEL may be located on the common electrode 573. The encapsulation layer TFEL may include at least one inorganic layer to prevent permeation of oxygen or moisture into the emission material layer EML. In addition, the encapsulation layer TFEL may include at least one organic film to protect the emission material layer EML from particles such as dust. For example, the encapsulation layer TFEL may include a first inorganic encapsulation layer TFE1, an organic encapsulation layer TFE2 and a second inorganic encapsulation layer TFE3.

The first inorganic encapsulation film TFE1 may be located on the common electrode 573, the organic encapsulation film TFE2 may be located on the first inorganic encapsulation film TFE1, and the second inorganic encapsulation film TFE3 may be located on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another. The organic encapsulation film TFE2 may be an organic film such as an acryl resin, an epoxy resin, a phenolic resin, a polyamide resin, a polyimide resin, etc.

The touch detecting layer TDL may be located on the encapsulation layer TFEL. The touch detecting layer TDL includes a first touch insulating layer TINS1, bridge electrodes BE, a second touch insulating layer TINS2, the driving electrodes TE, the sensing electrodes RE, and a third touch insulating layer TINS3. The touch detecting layer TDL may sense a touch of a person or an object using sensor electrodes.

The first touch insulating layer TINS1 may be located on the encapsulation layer TFEL. The first touch insulating layer TINS1 may be implemented as an inorganic film, for example, a silicon nitride layer, a silicon oxynitride layer, a silicon oxide layer, a titanium oxide layer, or an aluminum oxide layer.

The bridge electrodes BE may be arranged on the first touch insulating layer TINS1. The bridge electrodes BE may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second touch insulating layer TINS2 may be located over the bridge electrodes BE. The second touch insulating layer TINS2 may be implemented as an inorganic layer, for example, a silicon nitride layer, a silicon oxynitride layer, a silicon oxide layer, a titanium oxide layer, or an aluminum oxide layer. Alternatively, the second touch insulating layer TINS2 may be made of an organic layer such as an acryl resin, an epoxy resin, a phenolic resin, a polyamide resin and a polyimide resin.

The driving electrodes TE and the sensing electrodes RE may be arranged on the second touch insulating layer TINS2. The driving electrodes TE and the sensing electrodes RE may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The driving electrodes TE and the sensing electrodes RE may overlap with the bridge electrodes BE in the third direction DR3. The driving electrodes TE may be connected to the bridge electrodes BE through touch contact holes TCNT1 penetrating through the first touch insulating layer TINS1.

The third touch insulating layer TINS3 may be formed on the driving electrodes TE and the sensing electrodes RE. The third touch insulating layer TINS3 may provide a flat surface over the driving electrodes TE, the sensing electrodes RE and the bridge electrodes BE which have different heights. The third touch insulating layer TINS3 may be made of an organic layer such as an acryl resin, an epoxy resin, a phenolic resin, a polyamide resin and a polyimide resin.

Hereinafter, a crystal sensor according to an embodiment of the present disclosure, and a thin-film deposition device including the same will be described with reference to the accompanying drawings.

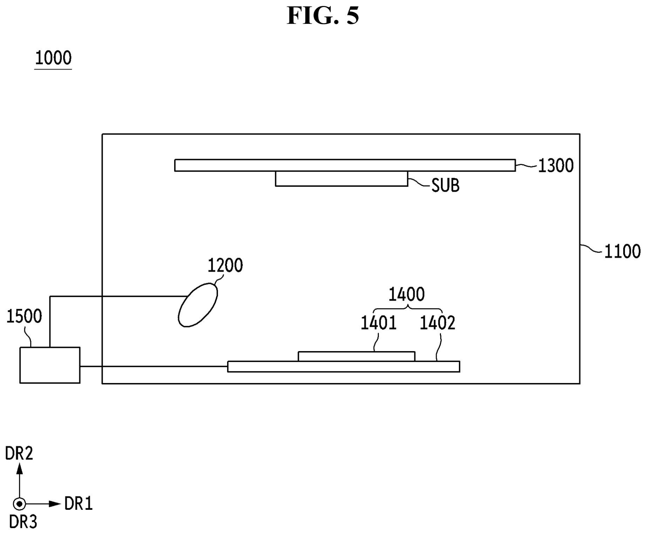

FIG. 5 is a view of a thin-film deposition device according to an embodiment of the present disclosure.

Referring to FIG. 5, a thin-film deposition device 1000 may include a chamber 1100, a crystal sensor 1200, a support 1300, a deposition unit 1400, and a controller 1500.

The chamber 1100 may provide a space for performing a deposition process. The space may be maintained in a high vacuum state to prevent foreign substances from entering from the outside and to ensure the straightness of a deposition material.

The support 1300 may be placed in the chamber 1100 to support the substrate SUB. One or more substrates SUB may be placed on the support 1300. The support 1300 may be installed so that it can move up and down and/or left and right. In addition, the support 1300 may be installed so that it can rotate.

The deposition unit 1400 may be placed in the chamber 1100 on the opposite side of the support 1300 to perform a process of depositing a deposition material on the substrate SUB. The deposition unit 1400 may include a deposition source 1401 and a heater 1402.

The deposition source 1401 may include a space in which a deposition material is accommodated. The deposition material is not particularly limited as long as it is used for fabricating the display device 1. The deposition material may include an inorganic material, a metal, or an organic material that can be sublimated or vaporized.

The heater 1402 may heat the deposition source 1401. The heater 1402 may heat the deposition source 1401 to sublimate or vaporize the deposition material accommodated in the deposition source 1401. The sublimated or vaporized deposition material may be sprayed toward the substrate SUB. When the deposition material passes through a mask, it may be deposited on the substrate SUB in a certain pattern.

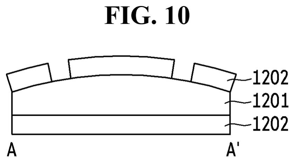

The controller 1500 may be electrically connected to the crystal sensor 1200 and the heater 1402. The controller 1500 receives from the crystal sensor 1200 information on the degree of changes in the natural vibration frequency of a crystal disc 1201 (See FIG. 10). The controller 1500 may measure the amount and deposition rate of a deposition material deposited on the substrate SUB based on the degree of changes in the natural vibration frequency of the crystal disc 1201. The controller 1500 may transmit a command to the heater 1402 to control the temperature of the heater 1402 based on the measured amount and deposition rate of the deposition material.

The crystal sensor 1200 may detect the rate at which the deposition material is deposited on the substrate SUB. The crystal sensor 1200 may be installed adjacent to the deposition unit 1400. Alternatively, the crystal sensor 1200 may be installed adjacent to the support 1300.

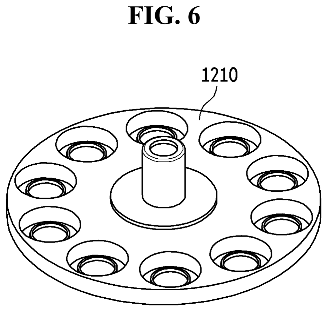

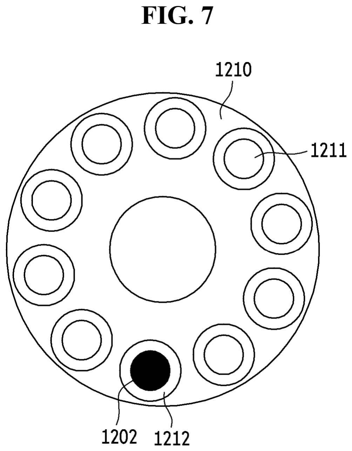

FIG. 6 is a perspective view of a crystal sensor according to an embodiment of the present disclosure. FIG. 7 is a plan view showing a sensing surface of a crystal sensor according to an embodiment of the present disclosure.

Referring to FIGS. 6 and 7, the crystal sensor 1200 may include a body portion 1210, a spare sensing portion 1211, and a sensing portion 1212. The body portion 1210 may include a plurality of spare sensing portions 1211 and sensing portions 1212. The spare sensing portion 1211 and the sensing portion 1212 may include a crystal disc 1201 and an electrode layer 1202. While the spare sensing portion 1211 is closed, the sensing portion 1212 may have a structure in which the electrode layer 1202 is exposed to the outside through an opening.

If the lifetime of the electrode layer 1202 of the sensing portion 1212 is over during the sensing operation, the sensing operation is interrupted, and the opening of the sensing portion 1212 is closed. Instead, the electrode layer 1202 included in the spare sensing portion 1211 is exposed through the opening of the sensing portion 1212 so that the sensing operation may be resumed.

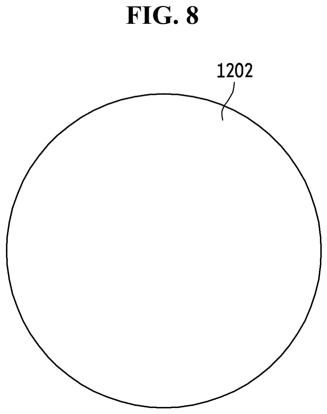

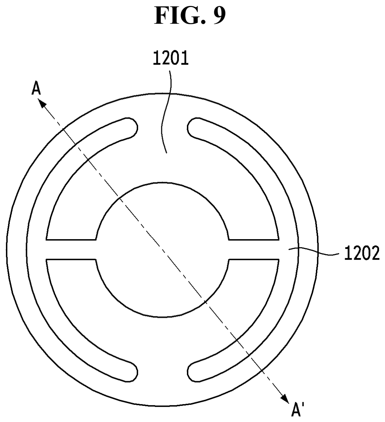

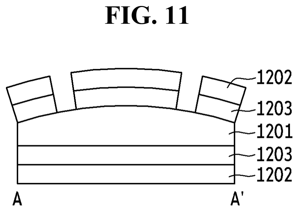

FIG. 8 is a plan view showing a surface of a crystal sensor according to an embodiment of the present disclosure. FIG. 9 is a plan view showing the opposite surface of the crystal sensor according to the embodiment of the present disclosure. FIG. 10 is a cross-sectional view according to a first embodiment, taken along line A - A' of FIG. 9. FIG. 11 is a cross-sectional view according to a second embodiment, taken along line A - A' of FIG. 9.

Referring to FIGS. 8 to 11, the crystal sensor 1200 may include a crystal disc 1201, an electrode layer 1202, and an adhesive layer 1203. The electrode layer 1202 may be placed on the crystal disc 1201. As a deposition material is deposited on the electrode layer 1202, the natural vibration frequency of the crystal disc 1201 may change. The amount of the deposition material deposited on the substrate SUB may be sensed by measuring the degree of changes in the natural vibration frequency of the crystal disc 1201.

The surface of the crystal sensor of FIG. 8 may be a deposition surface. The electrode layer 1202 may be placed on the deposition surface. The electrode layer 1202 of the deposition surface may be exposed through the opening of the sensing portion 1212 to perform the sensing operation.

The opposite surface of the crystal sensor of FIG. 9 may be an electrode surface. The electrode surface may be connected to the controller 1500 and may transmit the degree of changes in the natural vibration frequency of the crystal disc 1201 to the controller 1500.

When the crystal sensor 1200 operates, the crystal disc 1201 vibrates at the natural vibration frequency, which is referred to as the piezoelectric effect. The natural vibration frequency of the crystal disc 1201 may vary depending on the thickness of the crystal disc 1201, and the material and thickness forming the electrode.

As the deposition material is deposited on the electrode layer 1202 of the deposition surface, the natural vibration frequency of the crystal disc 1201 changes. The controller 1500 may collect information on the degree of changes in the natural vibration frequency of the crystal disc 1201, and may measure the amount of the deposition material deposited on the substrate SUB.

For example, as the deposition material is deposited on the electrode layer 1202 of the deposition surface, the natural vibration frequency of the crystal disc 1201 may decrease. If the reduction rate per second of the natural vibration frequency of the crystal disc 1201 is constant, it may be determined that the deposition rate of the deposition material is constant.

Variations in the deposition rate may be equal to or less than 0.1 angstroms per second (Å/s). The variations in the deposition rate may refer to the degree of deviations from a reference deposition rate. For example, when the reference deposition rate is 1.0 Å/s, if the deposition rate is 1.02 Å/s or 0.98 Å/s, the variations in the deposition rate may be 0.02 Å/s. Alternatively, when the reference deposition rate is 1.0 Å/s, if the deposition rate is 1.25 Å/s or 0.9 Å/s, variations in the deposition rate may be 0.25 Å/s based on the deposition rate of 1.25 Å/s that deviates the most from the reference deposition rate.

If the deposition rate detected by the crystal sensor 1200 is higher than the reference value, the controller 1500 may lower the temperature of the heater 1402. If the deposition rate detected by the crystal sensor 1200 is lower than the reference value, the controller 1500 may increase the temperature of the heater 1402.

Referring to FIG. 10, electrode layers 1202 may be placed on the opposite surfaces of the crystal disc 1201, respectively. The binding energy between the electrode layer 1202 and the deposition material may be calculated using the Vienna Ab initio Simulation Package (VASP) and may satisfy Equation 1 below: ${E}_{A} - \left({E}_{B}+{E}_{C}\right) \leq - 3 electron volts \left(eV\right) ,$ where EA denotes the total enthalpy of the electrode layer 1202 and the deposition material calculated using the VASP when the electrode layer 1202 and the deposition material are bonded together, EB denotes the enthalpy of the electrode layer 1202 calculated using the VASP before the electrode layer 1202 is bonded with the deposition material, and EC denotes the enthalpy of the deposition material calculated using the VASP before the deposition material is bonded with the electrode layer 1202.

The Vienna Ab initio Simulation Package (VASP) is a software package for performing Ab initio quantum mechanical calculations using either Vanderbilt pseudopotentials, or the projector augmented wave method, and a plane wave basis set. The VASP may be performed through first-principles calculation. The first-principles calculation refers to a method that involves calculation of the structural and thermodynamic properties of atoms and molecules based on electron-nucleus interactions and electron-electron interactions. For reference, the calculations in the present invention were conducted using VASP version 5.4. While calculation outcomes may vary depending on specific computational parameters, the present invention employed standard calculation conditions based on a generalized gradient approximation (GGA) functional.

When the electrode layer 1202 is arranged in a lattice structure on the surface of the crystal disc 1201, the deposition material may be deposited at the atomic level on the surface of the electrode layer 1202. Accordingly, EA may denote the enthalpy calculated using the VASP when the deposition material at the atomic level is bonded on the surface lattice structure of the electrode layer 1202, EB may denote the enthalpy of the surface lattice structure of the electrode layer 1202 calculated using the VASP, and EC may denote the enthalpy of the deposition material at the atomic level calculated using the VASP.

For example, when the electrode layer 1202 is chromium (Cr) and the deposition material is lithium (Li), the enthalpy when lithium (Li) atoms are bonded on the surface lattice of chromium (Cr) may be -242.834 eV, the enthalpy of the surface lattice of chromium (Cr) may be -238.244 eV, and the enthalpy of lithium (Li) atoms may be -0.294 eV. At this time, the binding energy between chromium (Cr) and lithium (Li) may be -4.316 eV. Since the binding energy between chromium (Cr) and lithium (Li) is less than -3 eV, it satisfies Equation 1 above.

The binding energy represents the strength of the bond. The larger the absolute value of the binding energy of two substances is, the stronger the bond between the two substances is.

Previously, a crystal sensor can detect the amount and deposition rate of a deposition substance by detecting the weight of the deposition material deposited on the surface of the electrode layer 1202. Unfortunately, if a material with a small element weight, such as lithium (Li) and magnesium (Mg), is deposited on the surface of the electrode layer, noise may occur in changes in the natural vibration frequency of the crystal plate, making it difficult to accurately measure the deposition amount. For example, when aluminum (Al) with low bonding strength to lithium (Li) is used as the electrode layer, lithium (Li) weakly bonded on the electrode layer may fall off by another lithium (Li) vaporized from the deposition source, such that noise may occur in the natural vibration frequency of the crystal plate.

According to the embodiment of the present disclosure, the crystal sensor 1200 uses a material having a high bonding strength with the deposition material (large absolute value of binding energy) as the electrode layer 1202, so that it is possible to accurately detect the amount and deposition rate of the deposition material deposited on the surface of the electrode layer 1202. In particular, the detected deposition rate can be constant even when a material with a small element weight, such as lithium (Li) and magnesium (Mg), is used as the deposition material.

Table 1 below shows the binding energy between the electrode layer 1202 and the deposition material.

**[Table 1]**

| Electrode Layer | Deposition Material (eV) | | | |
|---|---|---|---|---|
| | Li | Yb | Mg | Ag |
| Ta | -8.487 | -8.776 | -7.990 | -8.869 |
| Cr | -4.316 | -2.797 | -0.860 | -1.552 |
| Al | -1.757 | -1.598 | -1.002 | -2.095 |
| Ti | -2.145 | -2.375 | -1.825 | -2.957 |
| Au | -2.628 | -3.060 | -1.868 | -2.064 |
| Ag | -2.079 | -1.931 | -1.184 | -1.937 |
| Ni | -2.607 | -3.456 | -2.170 | -2.357 |
| W | -2.288 | -2.867 | -2.091 | -2.726 |
| Mo | -2.337 | -2.401 | -1.997 | -2.660 |

Referring to Table 1 above, the electrode layer 1202 of the crystal sensor 1200 may include a material with a binding energy between the deposition material and the electrode layer 1202 that is less than -3 eV as the electrode layer 1202.

If the deposition material is lithium (Li), ytterbium (Yb), magnesium (Mg), or silver (Ag), tantalum (Ta) may be used as the electrode layer 1202.

If the deposition material is lithium (Li), the electrode layer 1202 may include chromium (Cr) or tantalum (Ta).

If the deposition material is ytterbium (Yb), the electrode layer 1202 may include gold (Au), tantalum (Ta), or nickel (Ni). It should be noted that ytterbium (Yb) is a material that is easily sensed, and accordingly the electrode layer 1202 may include gold (Au) or titanium (Ti).

If the deposition material is magnesium (Mg), the electrode layer 1202 may include tantalum (Ta). It should be noted that magnesium (Mg) is a material that is easily sensed, and accordingly the electrode layer 1202 may include gold (Au) or titanium (Ti).

If the deposition material is silver (Ag), the electrode layer 1202 may include tantalum (Ta). It should be noted that silver (Ag) is a material that is easily sensed, and accordingly the electrode layer 1202 may include gold (Au), aluminum (Al), titanium (Ti) or chromium (Cr).

Referring to FIG. 11, the crystal sensor 1200 may further include an adhesive layer 1203 located between the crystal disc 1201 and the electrode layer 1202. The adhesive layer 1203 can improve the adhesion between the crystal disc 1201 and the electrode layer 1202. The adhesive layer 1203 can increase the electrical conductivity of the crystal sensor 1200. By increasing the electrical conductivity of the crystal sensor 1200, the sensitivity of the crystal sensor 1200 to detect the amount and deposition rate of a deposition material can be improved.

The adhesive layer 1203 may include at least one of: chromium (Cr), aluminum (Al), titanium (Ti), gold (Au), silver (Ag), nickel (Ni), molybdenum (Mo), and tantalum (Ta).

Hereinafter, the embodiments of the present disclosure will be described in more detail. It should be understood that the embodiments of the present disclosure are merely illustrative and are not intended to limit the scope of the present disclosure.

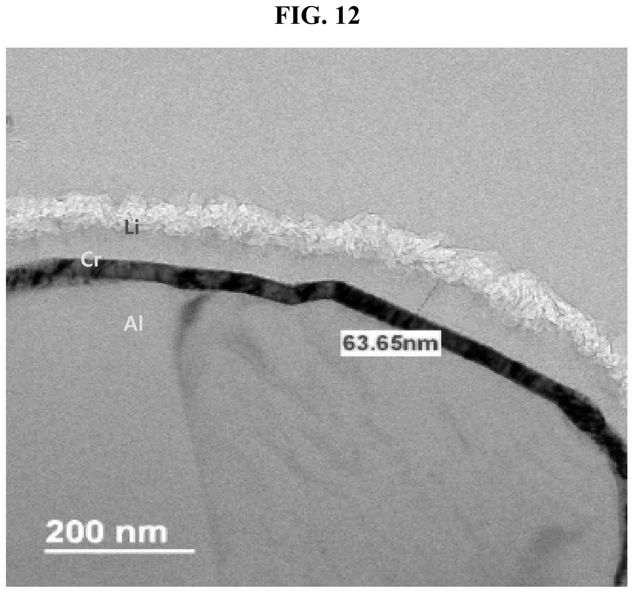

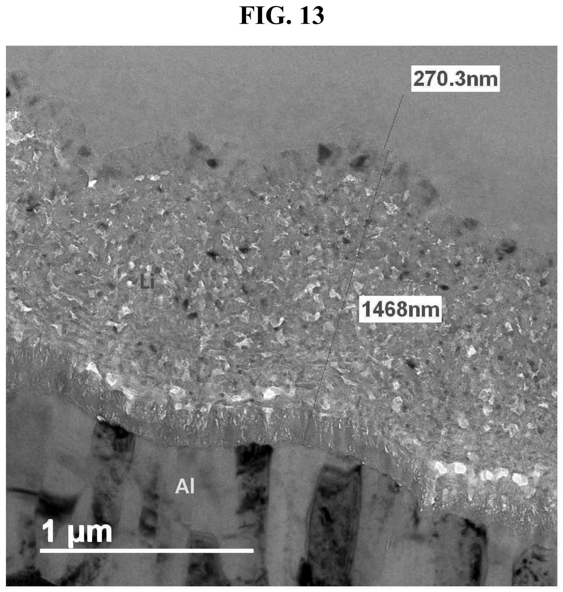

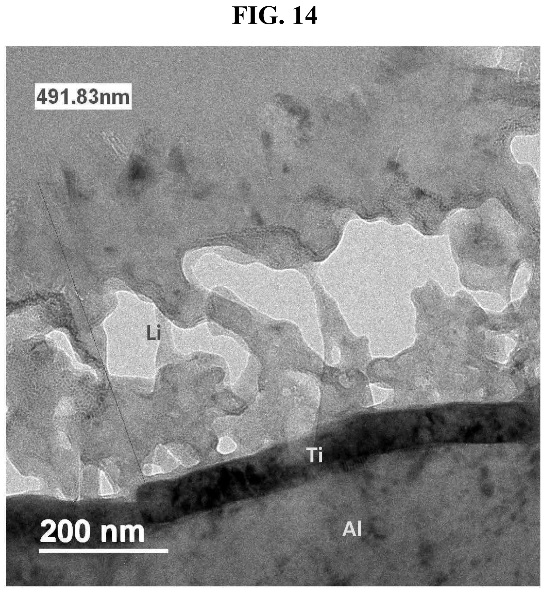

FIG. 12 is a transmission electron microscopy (TEM) image of a cross-section of a material in which aluminum (Al) / chromium (Cr) / lithium (Li) are sequentially stacked on one another. FIG. 13 is a transmission electron microscopy (TEM) image of a cross-section of a material in which aluminum (Al) / lithium (Li) are sequentially stacked on one another. FIG. 14 is a transmission electron microscopy (TEM) image of a cross-section of a material in which aluminum (Al) / titanium (Ti) / lithium (Li) are sequentially stacked on one another.

FIGS. 12 to 14 show cross-sections when lithium (Li) is deposited on chromium (Cr), aluminum (Al), and titanium (Ti), respectively. Referring to Table 1, the binding energy between chromium (Cr) and lithium (Li) is -4.316 eV, the binding energy between aluminum (Al) and lithium (Li) is -1.757 eV, and the binding energy between titanium (Ti) and lithium (Li) is -2.145 eV. It can be seen from FIGS. 12 to 14 that the film quality of lithium (Li) deposited on chromium (Cr) is more even than that of lithium (Li) deposited on aluminum (Al) and titanium (Ti). This may mean that the larger the absolute value of the binding energy is, the better the deposition material is deposited on the surface of the electrode layer 1202.

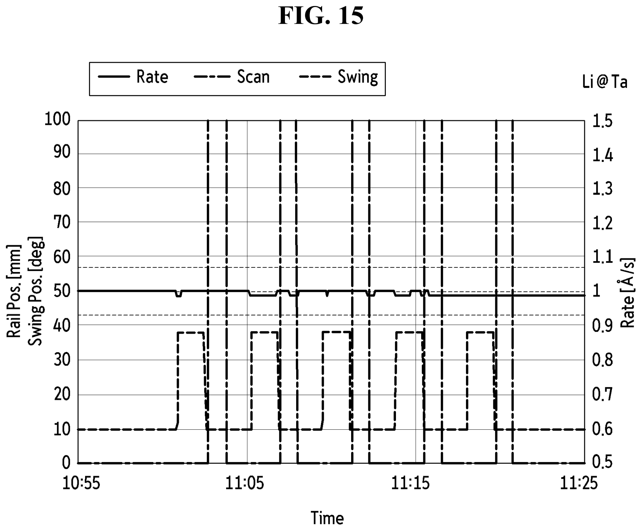

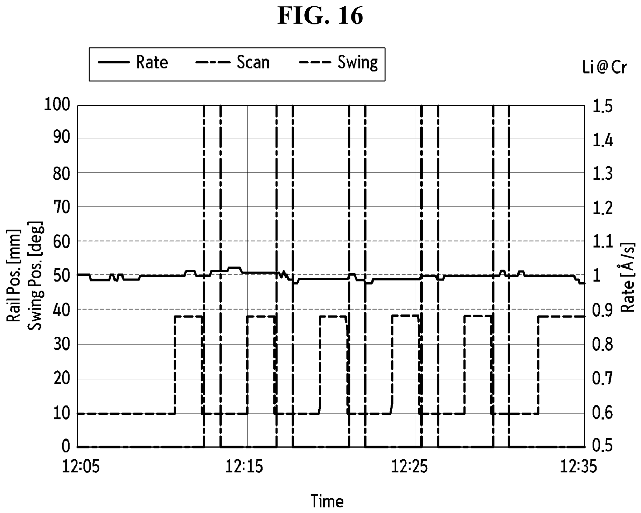

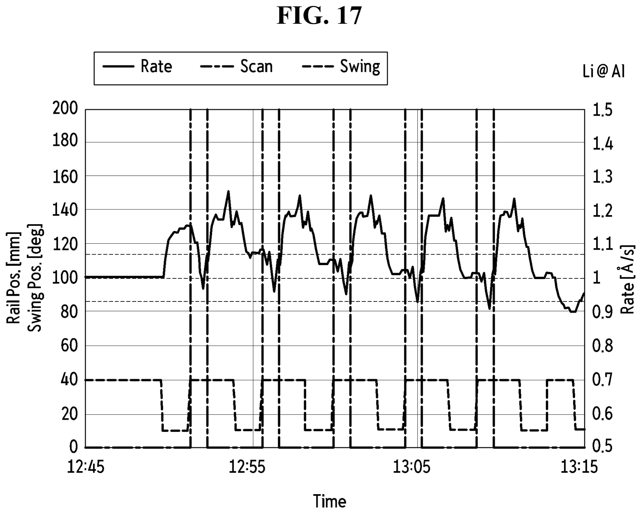

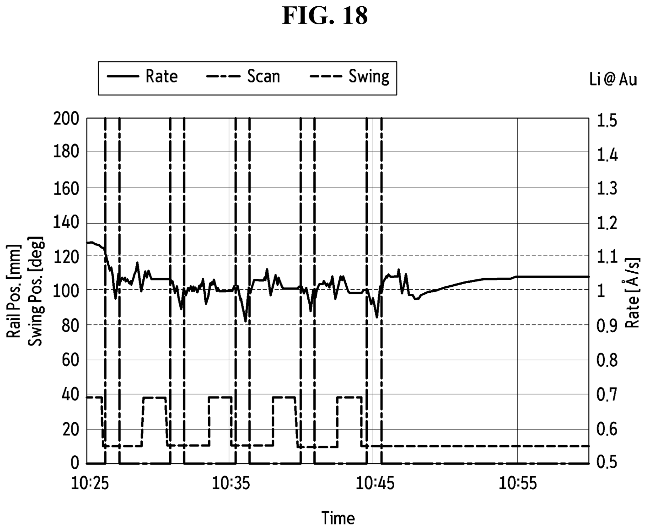

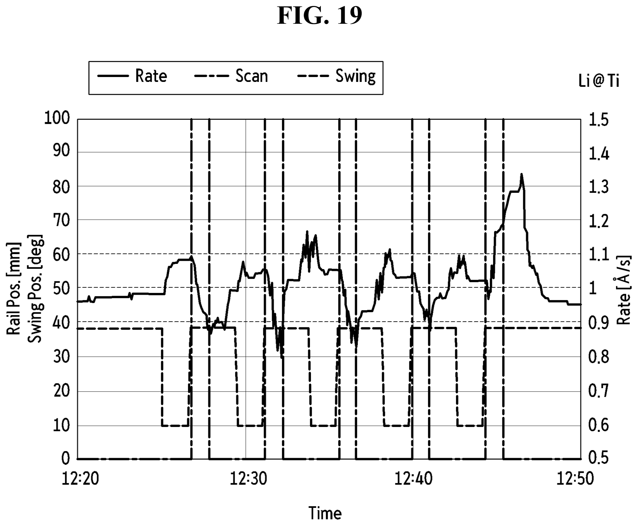

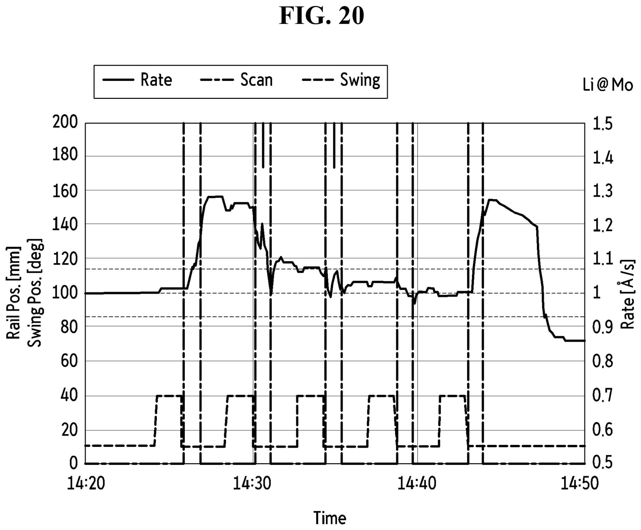

FIG. 15 is a graph showing the deposition rate over time of a crystal sensor including tantalum (Ta) as an electrode layer when lithium (Li) is deposited. FIG. 16 is a graph showing the deposition rate over time of a crystal sensor including chromium (Cr) as an electrode layer when lithium (Li) is deposited. FIG. 17 is a graph showing the deposition rate over time of a crystal sensor including aluminum (Al) as an electrode layer when lithium (Li) is deposited. FIG. 18 is a graph showing the deposition rate over time of a crystal sensor including gold (Au) as an electrode layer when lithium (Li) is deposited. FIG. 19 is a graph showing the deposition rate over time of a crystal sensor including titanium (Ti) as an electrode layer when lithium (Li) is deposited. FIG. 20 is a graph showing the deposition rate over time of a crystal sensor including molybdenum (Mo) as an electrode layer when lithium (Li) is deposited.

In the graphs shown in FIGS. 15 to 20, dash-dot lines Scan represent the degree to which the support 1300 moves in the third direction DR3, and dashed lines Swing represent the degree to which the support 1300 moves in the first direction DR1.

Table 2 below shows the binding energy, deposition rate, and variations in deposition rate according to the material of the electrode layer when lithium (Li) is deposited.

**[Table 2]**

| Electrode Layer | Binding Energy (eV) | Deposition Rate (Å/s) | Variations In Deposition Rate (Å/s) |
|---|---|---|---|
| Ta | -8.487 | 1.0 ± 0.02 | 0.02 |
| Cr | -4.316 | 1.0 ± 0.02 | 0.02 |
| Al | -1.757 | 1.0 ± 0.25 | 0.25 |
| Au | -2.628 | 1.0 ± 0.14 | 0.14 |
| Ti | -2.145 | 1.0 ± 0.33 | 0.33 |
| Mo | -2.337 | 1.0 ± 0.28 | 0.28 |

Referring to FIGS. 15 to 20 and Table 2, when lithium (Li) is used as the deposition material, it can be seen that the variations in deposition rate is small, i.e., approximately 0.02 Å/s if tantalum (Ta) and chromium (Cr) satisfying Equation 1 above are used as the electrode layer, while the variations in deposition rate is equal to or greater than 0.1 Å/s if aluminum (Al), gold (Au), titanium (Ti) and molybdenum (Mo) are used as the electrode layer.

It can be seen from FIGS. 15 and 16 that the deposition rate over time is generally constant. On the contrary, it can be seen from FIGS. 17 to 20 that variations in deposition rate increases over time as the support 1300 moves, and variations in deposition rate over time is not constant even while the support 1300 does not move.

When lithium (Li) is used as the deposition material, it may be desired to use tantalum (Ta) or chromium (Cr) as the electrode layer 1202 of the crystal sensor 1200.

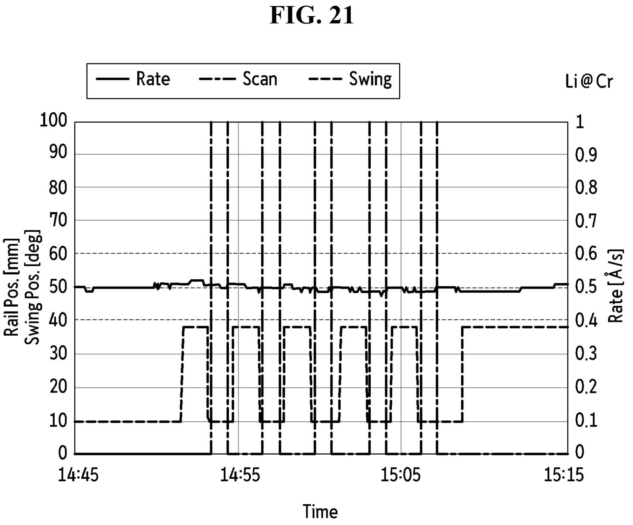

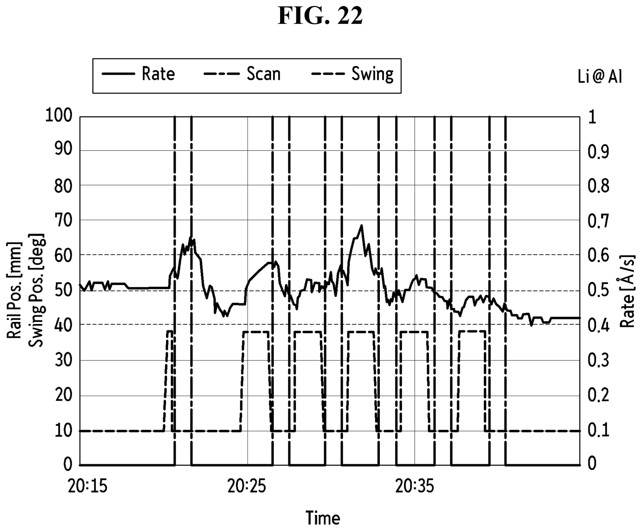

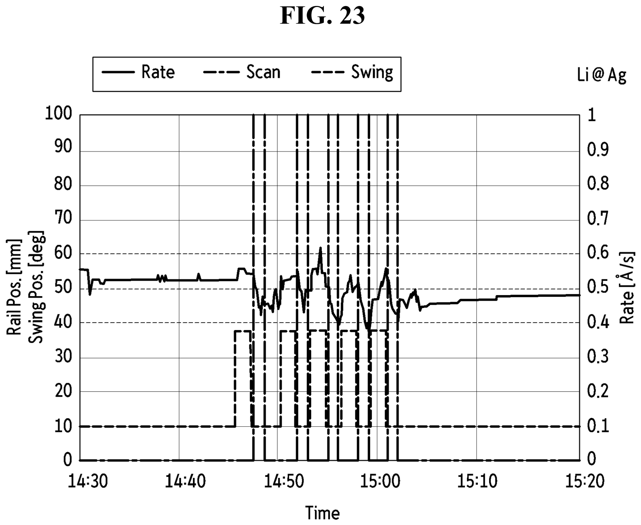

FIG. 21 is a graph showing the deposition rate over time of a crystal sensor including chromium (Cr) as an electrode layer when lithium (Li) is deposited. FIG. 22 is a graph showing the deposition rate over time of a crystal sensor including aluminum (Al) as an electrode layer when lithium (Li) is deposited. FIG. 23 is a graph showing the deposition rate over time of a crystal sensor including silver (Ag) as an electrode layer when lithium (Li) is deposited.

Table 3 below shows the binding energy, deposition rate, and variations in deposition rate according to the material of the electrode layer when lithium (Li) is deposited.

**[Table 3]**

| Electrode Layer | Binding Energy (eV) | Deposition Rate (Å/s) | Variations in Deposition Rate (Å/s) |
|---|---|---|---|
| Cr | -4.316 | 0.5 ± 0.02 | 0.02 |
| Al | -1.757 | 0.5 ± 0.12 | 0.12 |
| Ag | -2.079 | 0.5 ± 0.28 | 0.28 |

Referring to FIGS. 21 to 23 and Table 3, when lithium (Li) is used as the deposition material, it can be seen that the variations in deposition rate is small, i.e., approximately 0.02 Å/s if chromium (Cr) satisfying Equation 1 above is used as the electrode layer, while the variations in deposition rate is equal to or greater than 0.1 Å/s if aluminum (Al) and silver (Ag) are used as the electrode layer. In particular, it can be seen that the variations in deposition rate is greater than 0.1 Å/s if aluminum (Al) and silver (Ag) are used as the electrode layer even when the deposition rate is slow, i.e., approximately 0.5 Å/s. If the variations in deposition rate are large, the deposition rate is not constant, and thus it may be difficult to evenly deposit the deposition material on the substrate SUB.

When lithium (Li) is used as the deposition material, the detected deposition rate can be constant by using tantalum (Ta) or chromium (Cr) as the electrode layer 1202 of the crystal sensor 1200. Since the constant deposition rate is detected, the deposition material can be evenly deposited on the substrate SUB.

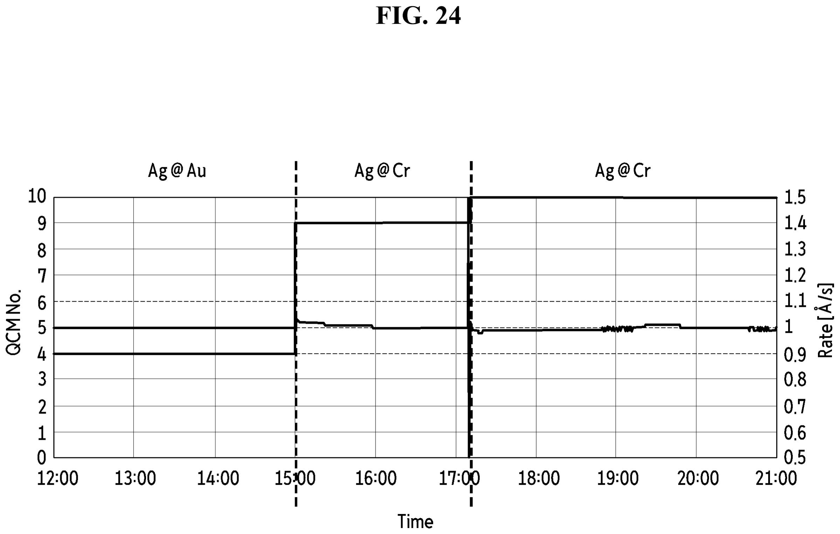

FIG. 24 is a graph showing the deposition rate over time by sequentially using a crystal sensor including gold (Au) and chromium (Cr) as an electrode layer when silver (Ag) is deposited.

It can be seen from FIG. 24 that the deposition rate is constant when gold (Au) is used and when chromium (Cr) is used as the electrode layer.

Referring to FIGS. 16, 21 and 24, when the crystal sensor 1200 including chromium (Cr) as the electrode layer 1202 is used, lithium (Li) and silver (Ag) can be evenly deposited on the substrate SUB because the detected deposition rate can be constant even when lithium (Li) and silver (Ag) are alternately stacked on one another.

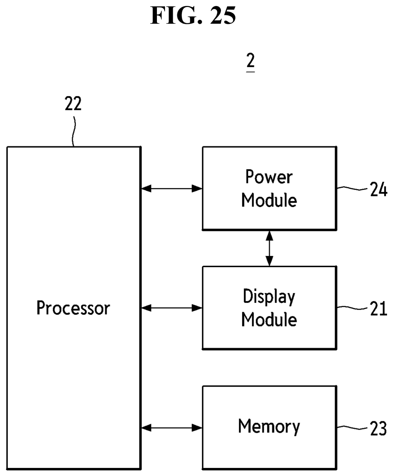

FIG. 25 is a block diagram of an electronic device according to an embodiment of the present disclosure. Referring to FIG. 25, an electronic device 2 according to an embodiment of the present disclosure may include a display module 21, a processor 22, a memory 23, and a power module 24.

The processor 22 may include at least one of: a central processing unit (CPU), an application processor (AP), a graphic processing unit (GPU), a communication processor (CP), an image signal processor (ISP), and a controller.

The memory 23 may store data information required for the operation of the processor 22 or the display module 21. When the processor 22 executes an application stored in the memory 23, an image data signal and/or an input control signal may be transmitted to the display module 21. The display module 21 may process the received signal and output image information through a display screen.

The power module 24 may include a power supply module such as a power adapter and a battery device, and a power conversion module that converts the power supplied by the power supply module to generate power required for the operation of the electronic device 2.

At least one of the elements of the electronic device 2 described above may be included in the display device 1 according to the embodiments described above. In addition, some of the individual modules functioning as a single module may be included in the display device 1 while some others may be provided separately from the display device 1. For example, the display device 1 may include the display module 21, and the processor 22, the memory 23 and the power module 24 may be provided as other devices inside the electronic device 2 than the display device 1.

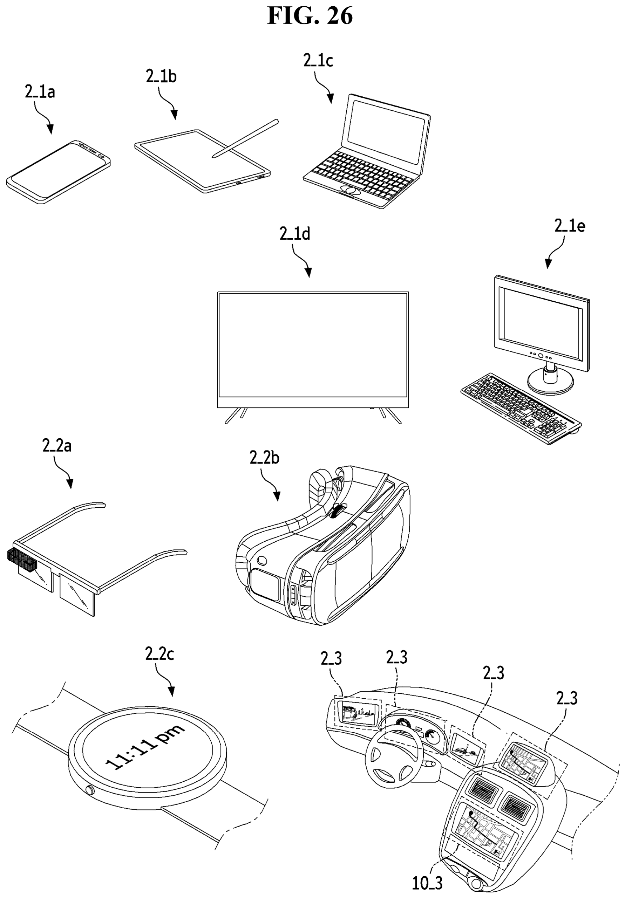

FIG. 26 is a view showing electronic devices according to a variety of embodiments of the present disclosure.

Referring to FIG. 26, a variety of electronic devices 2 employing the display devices according to the embodiments may include not only electronic devices for display images such as a smart phone 2_1a, a tablet PC 2_1b, a laptop computer 2_1c, a TV 2_1d and a desktop monitor 2_1e, but also wearable electronic devices including display modules such as smart glasses 2_2a, a head-mounted display 2_2b and a smart watch 2_2c, and electronic devices for vehicles 2_3 including display modules such as a center information display (CID) placed on the dashboard, the center fascia and the dashboard of a vehicle, and a room mirror display.

Although the embodiments of the present invention have been described with reference to the attached drawings, those skilled in the art will understand that the present invention can be implemented in other specific forms without changing the technical idea or some features of the present invention. Therefore, it should be understood that the embodiments described above are examples in all respects and not restrictive.

Embodiments are set out in the following clauses:
Clause 1. A crystal sensor comprising:
   a crystal disc; and
   an electrode layer on the crystal disc,
   wherein the crystal sensor is configured to sense an amount of a deposition material deposited on a substrate by measuring a degree of changes in a natural vibration frequency of the crystal disc as the deposition material is deposited on the electrode layer,
   wherein a binding energy between the electrode layer and the deposition material is calculated using Vienna Ab initio Simulation Package (VASP), and satisfies the following equation: ${E}_{A} - \left({E}_{B}+{E}_{C}\right) \leq - 3 electron volts \left(eV\right) ,$
   wherein E_{A} denotes a total enthalpy of the electrode layer and the deposition material calculated using the VASP when the electrode layer and the deposition material are bonded together, E_{B} denotes an enthalpy of the electrode layer calculated using the VASP when the electrode layer is not bonded with the deposition material, and E_{C} denotes an enthalpy of the deposition material calculated using the VASP when the deposition material is not bonded with the electrode layer.
Clause 2. The crystal sensor of clause 1, wherein the electrode layer comprises chromium (Cr) or tantalum (Ta).
Clause 3. The crystal sensor of clause 2, wherein the deposition material is lithium (Li).
Clause 4. The crystal sensor of clause 1, wherein the deposition material is ytterbium (Yb), and the electrode layer contains gold (Au), tantalum (Ta), or nickel (Ni).
Clause 5. The crystal sensor of clause 1, wherein the deposition material is magnesium (Mg), and the electrode layer contains tantalum (Ta).
Clause 6. The crystal sensor of any of clauses 1 to 5, further comprising:
   an adhesive layer between the crystal disc and the electrode layer.
Clause 7. The crystal sensor of clause 6, wherein the adhesive layer comprises at least one of: chromium (Cr), aluminum (Al), titanium (Ti), gold (Au), silver (Ag), nickel (Ni), molybdenum (Mo), and tantalum (Ta).
Clause 8. A thin-film deposition device comprising:
   a chamber;
   a support placed inside the chamber and which supports a substrate;
   a deposition unit located opposite to the support and which performs a process of depositing a deposition material on the substrate; and
   a crystal sensor installed adjacent to the deposition unit and which detects a deposition rate of the deposition material,
   wherein the crystal sensor comprises:
      a crystal disc; and
      an electrode layer on the crystal disc,
      wherein a binding energy between the electrode layer and the deposition material is calculated using Vienna Ab initio Simulation Package (VASP), and satisfies the following equation: ${E}_{A} - \left({E}_{B}+{E}_{C}\right) \leq - 3 eV ,$
      wherein E_{A} denotes a total enthalpy of the electrode layer and the deposition material calculated using the VASP when the electrode layer and the deposition material are bonded together, E_{B} denotes an enthalpy of the electrode layer calculated using the VASP when the electrode layer is not bonded with the deposition material, and E_{C} denotes an enthalpy of the deposition material calculated using the VASP when the deposition material is not bonded with the electrode layer.
Clause 9. The thin-film deposition device of clause 8, wherein the deposition unit comprises: a deposition source, which accommodates the deposition material; and a heater, which heats the deposition source.
Clause 10. The thin-film deposition device of clause 8 or clause 9, wherein the electrode layer comprises chromium (Cr) or tantalum (Ta).
Clause 11. The thin-film deposition device of clause 10, wherein the deposition material is lithium (Li).
Clause 12. The thin-film deposition device of any of clauses 8-11, further comprising:
   an adhesive layer located between the crystal disc and the electrode layer.
Clause 13. The thin-film deposition device of clause 12, wherein the adhesive layer comprises at least one of: chromium (Cr), aluminum (Al), titanium (Ti), gold (Au), silver (Ag), nickel (Ni), molybdenum (Mo), and tantalum (Ta).
Clause 14. The thin-film deposition device of any of clauses 8-13, wherein variations in the deposition rate is equal to or less than 0.1 angstroms per second (Å/s).
Clause 15. The thin-film deposition device of any of clauses 9-14, further comprising:
   a controller, which controls a temperature of the heater according to the deposition rate detected by the crystal sensor.
Clause 16. An electronic device comprising:
   a display module configured to provide images; and
   a processor configured to transmit an image data signal to the display module,
   wherein the display module is fabricated by a process comprising depositing a deposition material on a substrate,
   wherein the process is performed by a thin-film deposition device comprising a crystal sensor,
   wherein the crystal sensor comprises:
      a crystal disc; and
      an electrode layer located on the crystal disc,
      wherein a binding energy between the electrode layer and the deposition material is calculated using the Vienna Ab initio Simulation Package (VASP), and satisfies the following equation: ${E}_{A} - \left({E}_{B}+{E}_{C}\right) \leq - 3 eV$
      wherein E_{A} denotes an enthalpy calculated using the VASP when the electrode layer and the deposition material are bonded together, E_{B} denotes an enthalpy of the electrode layer calculated using the VASP, and E_{C} denotes an enthalpy of the deposition material calculated using the VASP.
Clause 17. The electronic device of clause 16, further comprising:
   an adhesive layer located between the crystal disc and the electrode layer.
Clause 18. The electronic device of clause 17, wherein the adhesive layer comprises at least one of: chromium (Cr), aluminum (Al), titanium (Ti), gold (Au), silver (Ag), nickel (Ni), molybdenum (Mo), and tantalum (Ta).

## Claims

1. A crystal sensor (1200) comprising:
a crystal disc (1201); and
an electrode layer (1202) on the crystal disc (1201),
wherein the crystal sensor (1200) is configured to sense an amount of a deposition material deposited on a substrate (SUB) by measuring a degree of changes in a natural vibration frequency of the crystal disc (1201) as the deposition material is deposited on the electrode layer (1202),
wherein a calculated binding energy between the electrode layer (1202) and the deposition material satisfies the following equation: ${E}_{A} - \left({E}_{B}+{E}_{C}\right) \leq - 3 electron volts \left(eV\right) ,$
wherein E_{A} denotes a total enthalpy of the electrode layer (1202) and the deposition material calculated when the electrode layer (1202) and the deposition material are bonded together, E_{B} denotes an enthalpy of the electrode layer (1202) calculated when the electrode layer (1202) is not bonded with the deposition material, and E_{C} denotes an enthalpy of the deposition material calculated when the deposition material is not bonded with the electrode layer (1202).

2. The crystal sensor of claim 1, wherein the binding energy is calculated using the Vienna Ab initio Simulation package (VASP)

3. The crystal sensor (1200) of claim 1 or claim 2, wherein the electrode layer (1202) comprises chromium (Cr) or tantalum (Ta);
optionally wherein the deposition material is lithium (Li).

4. The crystal sensor (1200) of claim 1 or claim 2, wherein the deposition material is ytterbium (Yb), and the electrode layer contains gold (Au), tantalum (Ta), or nickel (Ni).

5. The crystal sensor (1200) of claim 1 or claim 2, wherein the deposition material is magnesium (Mg), and the electrode layer (1202) contains tantalum (Ta).

6. The crystal sensor (1200) of any preceding claim, further comprising:
an adhesive layer (1203) between the crystal disc (1201) and the electrode layer (1202).

7. The crystal sensor (1200) of claim 6, wherein the adhesive layer (1203) comprises at least one of: chromium (Cr), aluminum (Al), titanium (Ti), gold (Au), silver (Ag), nickel (Ni), molybdenum (Mo), and tantalum (Ta).

8. A thin-film deposition device (1000) comprising:
a chamber (1100);
a support (1300) placed inside the chamber (1100) and which supports a substrate (SUB);
a deposition unit (1400) located opposite to the support (1300) and is configured to perform a process of depositing a deposition material on the substrate (SUB); and
a crystal sensor (1200) installed adjacent to the deposition unit (1400) and which detects a deposition rate of the deposition material,
wherein the crystal sensor (1200) comprises:
a crystal disc (1201); and
an electrode layer (1202) on the crystal disc (1201),
wherein a calculated binding energy between the electrode layer (1202) and the deposition material satisfies the following equation: ${E}_{A} - \left({E}_{B}+{E}_{C}\right) \leq - 3 eV ,$
wherein E_{A} denotes a total enthalpy of the electrode layer (1202) and the deposition material calculated when the electrode layer (1202) and the deposition material are bonded together, E_{B} denotes an enthalpy of the electrode layer (1202) calculated when the electrode layer (1202) is not bonded with the deposition material, and E_{C} denotes an enthalpy of the deposition material calculated when the deposition material is not bonded with the electrode layer (1202).

9. The thin-film deposition device (1000) of claim 8, wherein the deposition unit (1400) comprises: a deposition source (1401), for accommodating the deposition material; and a heater (1402), for heating the deposition source (1401).

10. The thin-film deposition device (1000) of claim 8 or claim 9, wherein the electrode layer (1402) comprises chromium (Cr) or tantalum (Ta);
optionally wherein the deposition material is lithium (Li).

11. The thin-film deposition device (1000) of any of claims 8-10, further comprising:
an adhesive layer (1203) located between the crystal disc (1201) and the electrode layer (1402);
optionally wherein the adhesive layer (1203) comprises at least one of: chromium (Cr), aluminum (Al), titanium (Ti), gold (Au), silver (Ag), nickel (Ni), molybdenum (Mo), and tantalum (Ta).

12. The thin-film deposition device (1000) of any of claims 8-11, wherein variations in the deposition rate is equal to or less than 0.1 angstroms per second (Å/s).

13. The thin-film deposition device (1000) of any of claims 9-12, further comprising:
a controller (1500), for controlling a temperature of the heater (1402) according to the deposition rate detected by the crystal sensor (1200).

14. An electronic device (2) comprising:
a display module (21) configured to provide images; and
a processor (22) configured to transmit an image data signal to the display module (21),
wherein the display module (21) is fabricated by a process comprising depositing a deposition material on a substrate (SUB),
wherein the process is performed by a thin-film deposition device (1000) comprising a crystal sensor (1200),
wherein the crystal sensor (1200) comprises:
a crystal disc (1201); and
an electrode layer (1202) located on the crystal disc (1201),
wherein a calculated binding energy between the electrode layer (1202) and the deposition material satisfies the following equation: ${E}_{A} - \left({E}_{B}+{E}_{C}\right) \leq - 3 eV$
wherein E_{A} denotes a total enthalpy of the electrode layer (1202) and the deposition material calculated when the electrode layer (1202) and the deposition material are bonded together, E_{B} denotes an enthalpy of the electrode layer (1202) calculated when the electrode layer (1202) is not bonded with the deposition material, and E_{C} denotes an enthalpy of the deposition material calculated when the deposition material is not bonded with the electrode layer (1202).

15. The electronic device (2) of claim 16, further comprising:
an adhesive layer (1203) located between the crystal disc (1201) and the electrode layer (1202);
optionally wherein the adhesive layer (1203) comprises at least one of: chromium (Cr), aluminum (Al), titanium (Ti), gold (Au), silver (Ag), nickel (Ni), molybdenum (Mo), and tantalum (Ta).
